# EUROPEAN PATENT APPLICATION

(11) **EP 4 600 741 A1**
(43) Date of publication of application: **13.08.2025**
(21) Application number: 23874709.1
(22) Date of filing: 26.09.2023
(51) Int. Cl.: G03F 7/004, C08F 2/44, C08F 292/00, G02B 5/20, G03F 7/038, G03F 7/075, H01L 33/50

(54) **PHOTOSENSITIVE RESIN COMPOSITION, PHOTOSENSITIVE RESIN COATING, PHOTOSENSITIVE DRY FILM, PATTERN FORMING METHOD, AND LIGHT-EMITTING ELEMENT**

(30) Priority: 05.10.2022 JP 2022160776
(71) Applicant: SHIN-ETSU CHEMICAL CO., LTD., Tokyo 1000005 (JP)
(72) Inventor: MARUYAMA Hitoshi, Annaka-shi, Gunma 379-0224 (JP); AOKI Shinji, Annaka-shi, Gunma 379-0195 (JP); NOJIMA Yoshihiro, Annaka-shi, Gunma 379-0195 (JP); TOBISHIMA Kazuya, Annaka-shi, Gunma 379-0195 (JP)
(74) Representative: Schicker, Silvia
(86) International application number: PCT/JP2023/034820
(87) International publication number: WO 2024/075581

(57) **Abstract**

The present invention is a photosensitive resin composition including (A) a phenolic hydroxy group-containing silicone resin; (B) a photo-acid generator; and (C) a quantum dot, wherein the quantum dot has a surface coating layer containing siloxane. This can provide: a photosensitive resin composition capable of easily forming a film having high lithography resolution and favorable luminous properties; a photosensitive resin film obtained by using the photosensitive resin composition, and a photosensitive dry film; patterning processes using these; and a light emitting device obtained by using the photosensitive resin composition.

## Description

### TECHNICAL FIELD

The present invention relates to: a photosensitive resin composition, a photosensitive resin film which utilize the photosensitive resin composition, a photosensitive dry film, a patterning process, and a light emitting device.

### BACKGROUND ART

Various methods have been proposed to form displays containing red, green, and blue subpixels. As one of the methods, there is a method in which light from an LED array is converted through a color conversion structure such that blue light having a shorter wavelength is converted to red and green light having longer wavelengths. Quantum dots have been employed for this color conversion.

Recently, such LED arrays are fabricated in micro size, and micro-LED displays using these have drawn attention. Although a method of forming a color conversion structure on an LED array includes a lithography process using a photosensitive material (Patent Document 1), further miniaturization has been demanded recently to use for a small display. In addition, there are high demands for luminous properties from the viewpoint of display clearness.

### CITATION LIST

### PATENT LITERATURE

Patent Document 1: JP 2021-089347 A

### SUMMARY OF INVENTION

### TECHNICAL PROBLEM

The present invention has been made in view of the above circumstances. An object of the present invention is to provide: a photosensitive resin composition capable of easily forming a film having high lithography resolution and favorable luminous properties; a photosensitive resin film obtained by using the photosensitive resin composition, and a photosensitive dry film; patterning processes using these; and a light emitting device obtained by using the photosensitive resin composition.

### SOLUTION TO PROBLEM

To solve the above problems, the present invention provides a photosensitive resin composition comprising:
(A) a phenolic hydroxy group-containing silicone resin;
(B) a photo-acid generator; and
(C) a quantum dot, wherein
the quantum dot has a surface coating layer containing siloxane.

Such a photosensitive resin composition can easily form a film having high lithography resolution and favorable luminous properties.

Further, in the present invention, the component (C) preferably has a skeleton having a phenolic hydroxy group in the surface coating layer.

Such a photosensitive resin composition can prevent the quantum dot from escaping in developing and impart a pattern high luminous properties.

Further, in the present invention, the component (A) preferably has a repeating unit represented by the following formula (a1) and a repeating unit represented by the formula (b1).

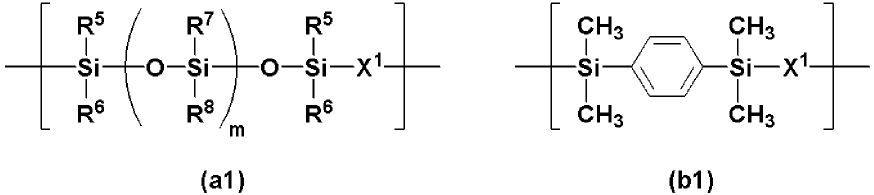

In the formulae, R⁵ to R⁸ each independently represent a monovalent hydrocarbon group having 1 to 8 carbon atoms; "m" represents an integer of 0 to 600; and X¹ represents a divalent group represented by the following formula (X1).

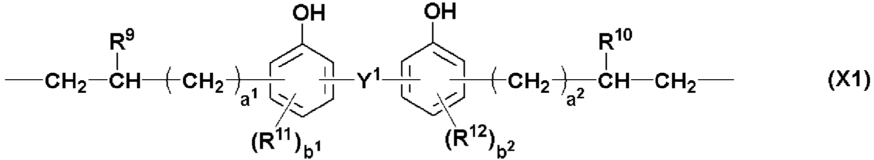

In the formula, Y¹ represents a single bond, a methylene group, a propane-2,2-diyl group, a 1,1,1,3,3,3-hexafluoropropane-2,2-diyl group, or a fluorene-9,9-diyl group; R⁹ and R¹⁰ each independently represent a hydrogen atom or a methyl group; R¹¹ and R¹² each independently represent an alkyl group having 1 to 4 carbon atoms or an alkoxy group having 1 to 4 carbon atoms; a¹ and a² each independently represent an integer of 0 to 7; and b¹ and b² each independently represent an integer of 0 to 2.

Such a photosensitive resin composition imparts the cured film to be obtained therefrom high reliability.

Further, in the present invention, the photosensitive resin composition preferably further comprises at least one crosslinking agent selected from the group consisting of a melamine compound, a guanamine compound, a glycoluril compound, and a urea compound, which have an average of two or more methylol groups and/or alkoxymethyl groups per molecule, amino condensates modified with formaldehyde or formaldehyde-alcohol, and phenol compounds having an average of two or more methylol groups or alkoxymethyl groups per molecule, as the component (D).

Such a photosensitive resin composition can further enhance strength of a resin film after photocuring.

Further, in the present invention, the quantum dot as the component (C) preferably has a ligand coordinated on the surface, the surface coating layer has a siloxane bond bonded to the ligand, and a substituent of the ligand has any one or more kinds of an amino group, a thiol group, a carboxy group, a phosphino group, a phosphine oxide group, or an ammonium ion.

The quantum dot having such a ligand easily coordinate to the surface and thus preferable.

Further, in the present invention, the component (C) is preferably contained in 5 to 80 mass% of the photosensitive resin composition.

Such a photosensitive resin composition can form a fine pattern while keeping favorable luminous properties.

Further, in the present invention, the photosensitive resin composition preferably further comprises (E) a solvent.

Such a photosensitive resin composition can improve coatability.

Further, the present invention provides a photosensitive resin film comprising a dried product of the photosensitive resin composition described above.

Such a photosensitive resin film has a high lithography resolution and favorable luminous properties.

Further, the present invention provides a photosensitive dry film comprising: a support film; and the photosensitive resin film described above on the support film.

Such a photosensitive dry film has a high lithography resolution and favorable luminous properties.

Further, the present invention provides a patterning process comprising steps of:
(i) applying the photosensitive resin composition described above onto a substrate to form a photosensitive resin film on the substrate;
(ii) exposing the photosensitive resin film to light; and
(iii) developing the exposed photosensitive resin film with a developer to dissolve and remove an unexposed portion, thereby to form a pattern.

Further, the present invention provides a patterning process comprising steps of:
(i') sticking the photosensitive resin film of the photosensitive dry film described above onto a substrate to form the photosensitive resin film on the substrate;
(ii) exposing the photosensitive resin film to light; and
(iii) developing the exposed photosensitive resin film with a developer to dissolve and remove an unexposed portion, thereby to form a pattern.

By such a patterning process, it is possible to form a pattern with high lithography resolution and obtain a pattern of a film having favorable luminous properties.

Further, the present invention provides a light emitting device comprising a cured film obtained by the patterning process described above.

Such a light emitting device has high lithography resolution and favorable luminous properties.

### ADVANTAGEOUS EFFECTS OF INVENTION

The inventive photosensitive resin composition can easily form a film having high resolution and favorable luminous properties thanks to containing a silicone resin having a phenolic hydroxy group, a photo-acid generator, and a quantum dot having a specific surface coating layer, and therefore is suitable as a light emitting device.

### DESCRIPTION OF EMBODIMENTS

As described above, it has been desired to develop a photosensitive resin composition capable of easily forming a film having high lithography resolution and favorable luminous properties; a photosensitive resin film obtained by using the photosensitive resin composition, and a photosensitive dry film; patterning processes using these; and a light emitting device obtained by using the photosensitive resin composition.

As a result of their diligent study of the above problems, the inventors found that a photosensitive resin composition containing (A) a phenolic hydroxy group-containing silicone resin, (B) a photo-acid generator, and (C) a quantum dot, which has a surface coating layer containing siloxane, can easily form a film (a photosensitive resin film) having high lithography resolution and favorable luminous properties, and have completed the present invention.

That is, the present invention is a photosensitive resin composition comprising:
(A) a phenolic hydroxy group-containing silicone resin;
(B) a photo-acid generator; and
(C) a quantum dot, wherein
the quantum dot has a surface coating layer containing siloxane.

Hereinafter, the present invention will be described in detail, but the present invention is not limited thereto.

### [Photosensitive Resin Composition]

The inventive photosensitive resin composition contains (A) a phenolic hydroxy group-containing silicone resin, (B) a photo-acid generator, and (C) a quantum dot having a specific surface coating layer. As necessary, the inventive photosensitive resin composition may further contain other components, such as (D) a crosslinking agent and (E) a solvent. Hereinbelow, each component constituting the photosensitive resin composition will be described.

### [(A) Phenolic Hydroxy Group-Containing Silicone Resin]

(A) the phenolic hydroxy group-containing silicone resin to be used in the present invention is not particularly limited as long as it has a phenolic hydroxy group.

Preferable examples include a silicone resin containing a repeating unit represented by the following formula (a1) and a repeating unit represented by the following formula (b1).

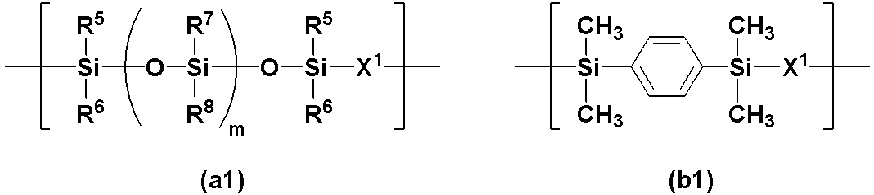

In the formula (a1), R⁵ to R⁸ each independently are a monovalent hydrocarbon group having 1 to 8 carbon atoms, preferably 1 to 6 carbon atoms. Examples of the monovalent hydrocarbon group include a linear, branched or cyclic alkyl group and aryl groups, and specific examples thereof include a methyl group, an ethyl group, a propyl group, a hexyl group, structural isomers thereof, a cyclohexyl group, a phenyl group. Among these, a methyl group and a phenyl group are preferable from the viewpoint of a readily available material.

In the formula (a1), "m" represents an integer of 0 to 600, preferably 0 to 400, and further preferably 0 to 200.

X¹ represents a divalent group represented by the following formula (X1).

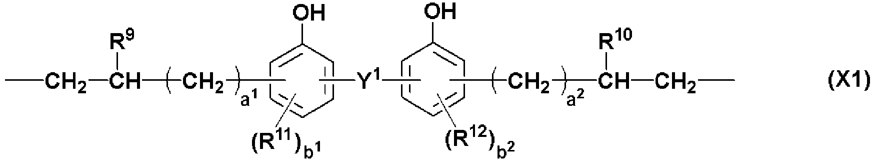

In the formula (X1), Y¹ represents a single bond, a methylene group, a propane-2,2-diyl group, a 1,1,1,3,3,3-hexafluoropropane-2,2-diyl group, or a fluorene-9,9-diyl group. R⁹ and R¹⁰ each independently represent a hydrogen atom or a methyl group. R¹¹ and R¹² each independently represent an alkyl group having 1 to 4 carbon atoms or an alkoxy group having 1 to 4 carbon atoms. a¹ and a² each independently represent an integer of 0 to 7, preferably an integer of 1 to 5, and more preferably an integer of 1 to 3. b¹ and b² each independently represent an integer of 0 to 2, preferably 0 or 1, and more preferably 0.

The alkyl group having 1 to 4 carbon atoms may be linear, branched, or cyclic. The specific examples thereof include a methyl group, an ethyl group, a propyl group, a butyl group, and structural isomers thereof. The alkoxy group having 1 to 4 carbon atoms may be linear, branched, or cyclic. Specific examples thereof include a methoxy group, an ethoxy group, a propoxy group, a butoxy group, and structural isomers thereof.

The resin (A) has repeating units so that it satisfies a1+b1=1. Assuming a1>0, it is preferable to satisfy 0.1≤a1≤0.9 and 0.1≤b1≤0.9. Furthermore, the silicone content is preferably 20 to 80 weight%, and more preferably 30 to 70 weight%.

(A) the phenolic hydroxy group-containing silicone resin provides film-forming ability, and the phenolic hydroxy group functions as a photocrosslinking point.

The repeating units each may be bonded randomly or as a block polymer. The siloxane units in each repeating unit may be bonded randomly or may have a plurality of blocks of the same type of siloxane units. In (A) the phenolic hydroxy group-containing silicone resin, the silicone (siloxane unit) content is preferably 30 to 80 mass% of.

(A) the phenolic hydroxy group-containing silicone resin preferably has a weight-average molecular weight (Mw) of 3,000 to 500,000, more preferably 5,000 to 200,000. Incidentally, in the present invention, Mw is a value measured in terms of polystyrene, by gel permeation chromatography (GPC) using tetrahydrofuran as an elution solvent.

(A) the phenolic hydroxy group-containing silicone resin is preferably manufactured by addition polymerizing a compound represented by the following formula (1), a compound represented by the following formula (2), and a compound represented by the following formula (3) in the presence of a metal catalyst. 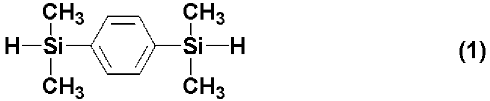 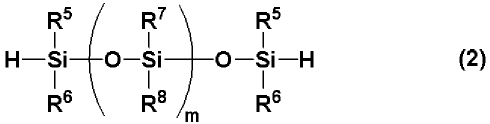 In the formulae, R⁵ to R⁸ and "m" are the same as defined above.

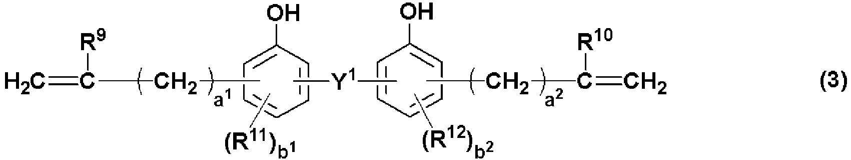

In the formula, R⁹ to R¹², Y¹, a¹, a², b¹, and b² are the same as defined above.

As the metal catalyst, it is possible to use: single platinum group metals, such as platinum (including platinum black), rhodium, and palladium; platinum chloride, chloroplatinic acid and chloroplatinates, such as H₂PtCl₄·xH₂O, H₂PtCl₆·xH₂O, NaHPtCl₆·xH₂O, KHPtCl₆·xH₂O, Na₂PtCl₆·xH₂O, K₂PtCl₄·xH₂O, PtCl₄·xH₂O, PtCl₂, and Na₂HPtCl₄·xH₂O (here, "x" is preferably an integer of 0 to 6, especially 0 or 6 is preferable.); alcohol-modified chloroplatinic acid (for example, those described in US 3220972 A); complex of chloroplatinic acid and olefin (for example, those described in US 3159601 A, US 3159662 A, and US 3775452 A); platinum group metals, such as platinum black and palladium, supported on a carrier, such as alumina, silica, and carbon; rhodium-olefin complex; chlorotris(triphenylphosphine)rhodium (so-called Wilkinson catalyst); and complexes of platinum chloride, chloroplatinic acid, or chloroplatinate with vinyl group-containing siloxanes (especially, vinyl group-containing cyclic siloxanes); etc.

The amount of the catalyst to be used is catalytic amount, generally, preferably is in an amount of 0.001 to 0.1 mass%, more preferably 0.01 to 0.1 mass% of sum of compounds other than solvents used in the addition polymerization as platinum group metals.

In the addition polymerization, a solvent may be used as necessary. The solvent is, for example, preferably hydrocarbon solvents, such as toluene and xylene.

The addition polymerization is preferably performed at a temperature of 40 to 150°C from a viewpoint of preventing catalyst deactivation and enabling short time completion of the polymerization, more preferably 60 to 120°C. The duration for the addition polymerization depends on a type and an amount of resin to be obtained, but is preferably about 0.5 to 100 hours, more preferably 0.5 to 30 hours, in order to avoid intervention of moisture in the addition polymerization system. When a solvent is used, by the distillation of the solvent after completion of the reaction, a phenolic hydroxy group-containing silicone resin can be obtained.

In the present invention, one kind of (A) the phenolic hydroxy group-containing silicone resin may be used, or two or more kinds thereof may be used in combination.

### [(B) Photo-Acid Generator]

The component (B) photo-acid generator is not particularly limited, as long as it is decomposed by light radiation and generates acid. The photo-acid generator preferably generates acid by irradiation with light having a wavelength of 190 to 500 nm. (B) the photo-acid generator is used as a curing catalyst. Examples of the photo-acid generator include onium salts, diazomethane derivatives, glyoxime derivatives, β-ketosulfone derivatives, disulfone derivatives, nitrobenzylsulfonate derivatives, sulfonate ester derivatives, imid-yl-sulfonate derivatives, oximesulfonate derivatives, iminosulfonate derivatives, triazine derivatives.

Examples of the onium salts include a sulfonium salt represented by the following formula (B1) or an iodonium salt represented by the following formula (B2).

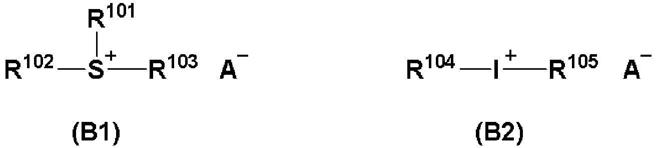

In the formulae (B1) and (B2), R¹⁰¹ to R¹⁰⁵ each independently represent an alkyl group having 1 to 12 carbon atoms and optionally having a substituent, an aryl group having 6 to 12 carbon atoms and optionally having a substituent, or an aralkyl group having 7 to 12 carbon atoms and optionally having a substituent. A⁻represents a non-nucleophilic counter ion.

The alkyl group may be linear, branched, or cyclic. Specific examples thereof include a methyl group, an ethyl group, an n-propyl group, an isopropyl group, a cyclopropyl group, an n-butyl group, an isobutyl group, a sec-butyl group, a tert-butyl group, a cyclobutyl group, an n-pentyl group, a cyclopentyl group, a cyclohexyl group, a norbornyl group, and an adamantyl group. Examples of the aryl group include a phenyl group, a naphthyl group, and a biphenylyl group. Examples of the aralkyl group include a benzyl group, and a phenethyl group.

Examples of the substituents include an oxo group, a linear, branched, or cyclic alkoxy group having 1 to 12 carbon atoms, a linear, branched, or cyclic alkyl group having 1 to 12 carbon atoms, an aryl group having 6 to 24 carbon atoms, an aralkyl group having 7 to 25 carbon atoms, an aryloxy group having 6 to 24 carbon atoms, and an arylthio group having 6 to 24 carbon atoms.

Preferable examples of R¹⁰¹ to R¹⁰⁵ include alkyl groups optionally having a substituent, such as a methyl group, an ethyl group, a propyl group, a butyl group, a cyclohexyl group, a norbornyl group, an adamantyl group, and a 2-oxocyclohexyl group; aryl groups optionally having a substituent, such as a phenyl group, a naphthyl group, a biphenylyl group, an o-, m- or p-methoxyphenyl group, an ethoxyphenyl group, an m- or p-tert-butoxyphenyl group, a 2-, 3- or 4-methylphenyl group, an ethylphenyl group, a 4-tert-butylphenyl group, a 4-butylphenyl group, a dimethylphenyl group, a terphenylyl group, a biphenylyloxyphenyl group, and a biphenylylthiophenyl group; and aralkyl groups optionally having a substituent, such as a benzyl group and a phenethyl group. Among these, aryl groups optionally having a substituent and aralkyl groups optionally having a substituent are more preferable.

Examples of the non-nucleophilic counter ion include halide ions, such as a chloride ion and a bromide ion; fluoroalkanesulfonate ions, such as a triflate ion, a 1,1,1-trifluoroethanesulfonate ion, and a nonafluorobutanesulfonate ion; arylsulfonate ions, such as a tosylate ion, a benzenesulfonate ion, a 4-fluorobenzenesulfonate ion, and a 1,2,3,4,5-pentafluorobenzenesulfonate ion; alkanesulfonate ions, such as a mesylate ion and a butanesulfonate ion; fluoroalkanesulfone imide ions, such as a trifluoromethanesulfone imide ion; fluoroalkanesulfonyl methide ions, such as a tris(trifluoromethanesulfonyl)methide ion; and borate ions, such as a tetrakisphenylborate ion and tetrakis(pentafluorophenyl)borate ion.

Examples of the diazomethane derivatives include a compound represented by the following formula (B3).

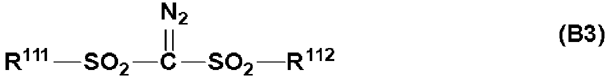

In the formula (B3), R¹¹¹ and R¹¹² each independently represent an alkyl group or halogenated alkyl group having 1 to 12 carbon atoms, an aryl group having 6 to 12 carbon atoms and optionally having a substituent, or an aralkyl group having 7 to 12 carbon atoms.

The alkyl group may be linear, branched, or cyclic. Specific examples thereof include those exemplified in the description of R¹⁰¹ to R¹⁰⁵. Examples of the halogenated alkyl group include a trifluoromethyl group, a 1,1,1-trifluoroethyl group, a 1,1,1-trichloroethyl group, and a nonafluorobutyl group.

Examples of the aryl group optionally having a substituent include a phenyl group; alkoxyphenyl groups, such as a 2-, 3- or 4-methoxyphenyl group, a 2-, 3- or 4-ethoxyphenyl group, and a 3- or 4-tert-butoxyphenyl group; alkylphenyl groups, such as a 2-, 3- or 4-methylphenyl group, an ethylphenyl group, a 4-tert-butylphenyl group, a 4-butylphenyl group, and a dimethylphenyl group; halogenated aryl groups, such as a fluorophenyl group, a chlorophenyl group, and a 1,2,3,4,5-pentafluorophenyl group; etc. Examples of the aralkyl group include a benzyl group and a phenethyl group.

Examples of the glyoxime derivatives include a compound represented by the following formula (B4).

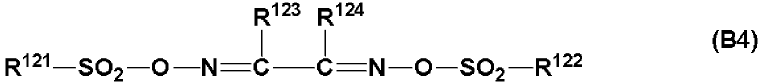

In the formula (B4), R¹²¹ to R¹²⁴ each independently represent an alkyl group or halogenated alkyl group having 1 to 12 carbon atoms, an aryl group having 6 to 12 carbon atoms and optionally having a substituent, or an aralkyl group having 7 to 12 carbon atoms. Alternatively, R¹²³ and R¹²⁴ may bond with each other to form a ring together with carbon atoms bonded with R¹²³ or R¹²⁴. When a ring is formed, a group which R¹²³ and R¹²⁴ are bonded with each other to form is a linear or branched alkylene group having 2 to 12 carbon atoms.

Examples of the alkyl group, the halogenated alkyl group, the aryl group optionally having a substituent, and the aralkyl group include those exemplified as R¹¹¹ and R¹¹². Examples of the linear or branched alkylene groups include an ethylene group, a propylene group, a butylene group, and a hexylene group.

Specific examples of the onium salts include diphenyliodonium trifluoromethanesulfonate, (p-tert-butoxyphenyl)phenyliodonium trifluoromethanesulfonate, diphenyliodonium p-toluenesulfonate, (p-tert-butoxyphenyl)phenyliodonium p-toluenesulfonate, triphenylsulfonium trifluoromethanesulfonate, (p-tert-butoxyphenyl)diphenylsulfonium trifluoromethanesulfonate, bis(p-tert-butoxyphenyl)phenylsulfonium trifluoromethanesulfonate, tris(p-tert-butoxyphenyl)sulfonium trifluoromethanesulfonate, triphenylsulfonium p-toluenesulfonate, (p-tert-butoxyphenyl)diphenylsulfonium p-toluenesulfonate, bis(p-tert-butoxyphenyl)phenylsulfonium p-toluenesulfonate, tris(p-tert-butoxyphenyl)sulfonium p-toluenesulfonate, triphenylsulfonium nonafluorobutanesulfonate, triphenylsulfonium butanesulfonate, trimethylsulfonium trifluoromethanesulfonate, trimethylsulfonium p-toluenesulfonate, cyclohexylmethyl(2-oxocyclohexyl)sulfonium trifluoromethanesulfonate, cyclohexylmethyl(2-oxocyclohexyl)sulfonium p-toluenesulfonate, dimethylphenylsulfonium trifluoromethanesulfonate, dimethylphenylsulfonium p-toluenesulfonate, dicyclohexylphenylsulfonium trifluoromethanesulfonate, dicyclohexylphenylsulfonium p-toluenesulfonate, bis(4-tert-butylphenyl)iodonium hexafluorophosphate, diphenyl(4-thiophenoxyphenyl)sulfonium hexafluoroantimonate, [4-(4-biphenylylthio)phenyl]-4-biphenylylphenylsulfonium tris(trifluoromethanesulfonyl)methide, triphenylsulfonium tetrakis(fluorophenyl)borate, tris[4-(4-acetylphenyl)thiophenyl]sulfonium tetrakis(fluorophenyl)borate, triphenylsulfonium tetrakis(pentafluorophenyl)borate, and tris[4-(4-acetylphenyl)thiophenyl]sulfonium tetrakis(pentafluorophenyl)borate.

Specific examples of the diazomethane derivatives include bis(benzenesulfonyl)diazomethane, bis(p-toluenesulfonyl)diazomethane, bis(xylenesulfonyl)diazomethane, bis(cyclohexylsulfonyl)diazomethane, bis(cyclopentylsulfonyl)diazomethane, bis(n-butylsulfonyl)diazomethane, bis(isobutylsulfonyl)diazomethane, bis(sec-butylsulfonyl)diazomethane, bis(n-propylsulfonyl)diazomethane, bis(isopropylsulfonyl)diazomethane, bis(tert-butylsulfonyl)diazomethane, bis(n-pentylsulfonyl)diazomethane, bis(isopentylsulfonyl)diazomethane, bis(sec-pentylsulfonyl)diazomethane, bis(tert-pentylsulfonyl)diazomethane, 1-cyclohexylsulfonyl-1-(tert-butylsulfonyl)diazomethane, 1-cyclohexylsulfonyl-1-(tert-pentylsulfonyl)diazomethane, and 1-tert-pentylsulfonyl-1-(tert-butylsulfonyl)diazomethane.

Specific examples of the glyoxime derivatives include bis-o-(p-toluenesulfonyl)-α-dimethylglyoxime, bis-o-(p-toluenesulfonyl)-α-diphenylglyoxime, bis-o-(p-toluenesulfonyl)-α-dicyclohexylglyoxime, bis-o-(p-toluenesulfonyl)-2,3-pentanedioneglyoxime, bis-(p-toluenesulfonyl)-2-methyl-3,4-pentanedioneglyoxime, bis-o-(n-butanesulfonyl)-α-dimethylglyoxime, bis-o-(n-butanesulfonyl)-α-diphenylglyoxime, bis-o-(n-butanesulfonyl)-α-dicyclohexylglyoxime, bis-o-(n-butanesulfonyl)-2,3-pentanedioneglyoxime, bis-o-(n-butanesulfonyl)-2-methyl-3,4-pentanedioneglyoxime, bis-o-(methanesulfonyl)-α-dimethylglyoxime, bis-o-(trifluoromethanesulfonyl)-α-dimethylglyoxime, bis-o-(1,1,1-trifluoroethanesulfonyl)-α-dimethylglyoxime, bis-o-(tert-butanesulfonyl)-α-dimethylglyoxime, bis-o-(perfluorooctanesulfonyl)-α-dimethylglyoxime, bis-o-(cyclohexanesulfonyl)-α-dimethylglyoxime, bis-o-(benzenesulfonyl)-α-dimethylglyoxime, bis-o-(p-fluorobenzenesulfonyl)-α-dimethylglyoxime, bis-o-(p-tert-butylbenzenesulfonyl)-α-dimethylglyoxime, bis-o-(xylenesulfonyl)-α-dimethylglyoxime, and bis-o-(camphorsulfonyl)-α-dimethylglyoxime.

Specific examples of the β-ketosulfone derivatives include 2-cyclohexylcarbonyl-2-(p-toluenesulfonyl)propane and 2-isopropylcarbonyl-2-(p-toluenesulfonyl)propane.

Specific examples of the disulfone derivatives include diphenyldisulfone and dicyclohexyldisulfone.

Specific examples of the nitrobenzylsulfonate derivatives include 2,6-dinitrobenzyl p-toluenesulfonate and 2,4-dinitrobenzyl p-toluenesulfonate.

Specific examples of the sulfonate ester derivatives include 1,2,3-tris(methanesulfonyloxy)benzene, 1,2,3-tris(trifluoromethanesulfonyloxy)benzene, and 1,2,3-tris(p-toluenesulfonyloxy)benzene.

Specific examples of the imid-yl-sulfonate derivatives include phthalimid-yl-triflate, phthalimid-yl-tosylate, 5-norbornene-2,3-dicarboxyimid-yl-triflate, 5-norbornene-2,3-dicarboxyimid-yl-tosylate, 5-norbornene-2,3-dicarboxyimid-yl-n-butylsulfonate, and n-trifluoromethylsulfonyloxynaphthylimide.

Specific examples of the oximesulfonate derivatives include α-(benzenesulfonium oxyimino)-4-methylphenylacetonitrile.

Specific examples of the iminosulfonate derivatives include (5-(4-methylphenyl)sulfonyloxyimino-5H-thiophen-2-ylidene)-(2-methylphenyl)acetonitrile and (5-(4-(4-methylphenylsulfonyloxy)phenylsulfonyloxyimino)-5H-thiophen-2-ylidene)-(2-methylphenyl)-acetonitrile.

Specific example of the triazine derivatives include 2-[2-(furan-2-yl)ethynyl]-4,6-bis(trichloromethyl)-s-triazine, 2-[2-(5-methylfuran-2-yl)ethynyl]-4,6-bis(trichloromethyl)-s-triazine, 2-(methoxyphenyl)-4,6-bis(trichloromethyl)-s-triazine, 2-[2-(4-methoxyphenyl)ethynyl]-4,6-bis(trichloromethyl)-s-triazine, and 2-[2-(3,4-dimethoxyphenyl)ethynyl]-4,6-bis(trichloromethyl)-s-triazine.

Additionally, 2-methyl-2-[(4-methylphenyl)sulfonyl]-1-[(4-methylthio)phenyl]-1-propane and the like are also suitably usable.

The component (B) photo-acid generator is particularly preferably the onium salts or the sulfonium salt, and the sulfonium salt is more preferable.

(B) the photo-acid generator is contained preferably in the range of 0.05 to 20 mass%, more preferably in the range of 0.5 to 10 mass% of the total amount of the photosensitive resin composition. When the photo-acid generator is contained within the above range, it is excellent in balance between sensitivity during exposure and developability and capable of obtaining a pattern having excellent resolution without residual film. One kind of the photo-acid generators may be used, or two or more kinds thereof may be used in combination.

### [(C) Quantum Dot Having Specific Surface Coating Layer]

A quantum dot is a nano-sized semiconductor substance. Atoms form a molecule, and the molecules constitute a small molecular aggregate called "cluster" to form a nanoparticle. When such a nanoparticle particularly exhibit semiconductor properties, it is called a quantum dot (quantum dot particle).

When a quantum dot is excited by receiving external energy, the quantum dot releases energy (emits light) according to corresponding energy band gap by itself (autonomously) .

(C) the quantum dot used in the present invention is not particularly limited as long as it has a surface coating layer containing siloxane, and can be used in any form. A quantum dot is mainly a nanoparticle of 10 nm or less, may be a nanowire, a nanorod, a nanotube, a nanocube, etc., and any shape can be applied. In the present invention, the average particle diameter of the quantum dot was determined by directly observing at least 20 particles using a transmission electron microscope (TEM), calculating the diameter of a circle having the same area as the projected area of the particle, and using the average value thereof.

(C) the quantum dot used in the present invention can be selected from any suitable materials, for example as semiconductor materials, selected from the group consisting of II-VI group, III-V group, IV group, IV-VI group, I-III-VI group, II-IV-V group, mixed crystals or alloys thereof, and compounds having a perovskite structure. Specific examples thereof include compounds containing ZnS, ZnSe, ZnTe, CdS, CdSe, CdTe, AlN, AlP, AlAs, AlSb, GaN, GaP, GaAs, GaSb, InN, InP, InAs, InSb, Si, Ge, Sn, Pb, PbS, PbSe, PbTe, SnS, SnSe, SnTe, AgGaS₂, AgInS₂, AgGaSe₂, AgInSe₂, CuGaS₂, CuGaSe₂, CuInS₂, CuInSe₂, ZnSiP₂, ZnGeP₂, CdSiP₂, CdGeP₂, CsPbCl₃, CsPbBr₃, CsPbI₃, CsSnCl₃, CsSnBr₃, or CsSnI₃, but not limited thereto.

(C) the quantum dot used in the present invention may have a core-shell structure. Shell materials capable of forming a core-shell structure are not particularly limited, but preferably has a large band gap and low lattice mismatch with respect to the core material, and can be arbitrarily combined according to the core material. Specific examples of the shell material include ZnO, ZnS, ZnSe, ZnTe, CdS, CdSe, CdTe, AlN, AlP, AlAs, AlSb, GaN, GaP, GaAs, GaSb, InN, InP, InAs, InSb, BeS, BeSe, BeTe, MgS, MgSe, MgTe, PbS, PbSe, PbTe, SnS, SnSe, SnTe, CuF, CuCl, CuBr, and CuI. One kind of these materials may be used, or two or more kinds thereof may be used as a mixed crystal made of a plurality of materials, and the materials are not limited thereto.

There are various methods for manufacturing (C) the quantum dot used in the present invention, such as a liquid phase method and a vapor phase method, but in the present invention, the methods are not particularly limited. From the viewpoint of exhibiting high fluorescence emission efficiency, it is preferable to use semiconductor nanoparticles obtained using a hot soap method or a hot injection method, in which a precursor species is reacted at high temperature in a nonpolar solvent having a high boiling point. In order to impart dispersibility in a nonpolar solvent and reduce surface flaws, it is desirable that organic ligands are coordinated on the surface.

The organic ligand preferably has an aliphatic hydrocarbon from the viewpoint of dispersibility. Examples of such an organic ligand include oleic acid, stearic acid, palmitic acid, myristic acid, lauric acid, decanoic acid, octanoic acid, oleylamine, stearyl(octadecyl)amine, dodecyl(lauryl)amine, decylamine, octylamine, octadecanethiol, hexadecanethiol, tetradecanethiol, dodecanethiol, decanethiol, octanethiol, trioctylphosphine, trioctylphosphine oxide, triphenylphosphine, triphenylphosphine oxide, tributylphosphine, and tributylphosphine oxide. One kind of the organic ligands may be used, or two or more kinds thereof may be used in combination.

(C) the quantum dot used in the present invention is coordinated with a ligand having a substituent capable of forming a siloxane bond in addition to the above-mentioned organic ligand. As the ligand having a substituent capable of forming a siloxane bond, it is desirable to have a substituent that interacts with or adsorbs to the quantum dot surface. Substituents that interact with or adsorb to the quantum dot surface include an amino group, a thiol group, a carboxy group, a mercapto group, a phosphino group, a phosphine group, a phosphine oxide group, a sulfonyl group, an ammonium ion, and a quaternary ammonium salt. Among these, an amino group, a carboxy group, a mercapto group, a phosphine group, and a quaternary ammonium salt are preferable from the viewpoint of coordination strength.

The surface of (C) the quantum dot used in the present invention is coated with siloxane. Therefore, the surface of the quantum dot has a substituent that can form a siloxane bond on the ligand having a substituent that interacts with or adsorbs. Substituents that can form a siloxane bond include compounds containing alkoxysilanes, such as a trimethoxysilyl group, a triethoxysilyl group, a dimethoxymethylsilyl group, a diethoxymethylsilyl group, a dimethylmethoxysilyl group, and an ethoxydimethylsilyl group; compounds having a silazane bond; compounds having an Si-OH bond; compounds having an Si-X (X: halogen) bond; and carboxylic acids. It is preferable to use a ligand containing alkoxysilane, silazane, or Si-OH because the reaction can proceed under mild conditions in which no acid is generated as a reaction by-product. A phenyl group-containing siloxane can be formed by reacting these with diphenyldisilanol or the like.

The coating amount of siloxane is not particularly limited, but is preferably in the range of 1 to 50 mass%, more preferably in the range of 5 to 30 mass% of mass of the quantum dots. When the coating amount of siloxane is too large, the quantum dot content decreases, but when it is within the above range, it is possible to improve the dispersibility in the base polymer and prevent the deterioration of the quantum dots during exposure.

(C) the quantum dot used in the present invention may further include a skeleton having a phenolic hydroxy group in the surface coating layer.

The skeleton having a phenolic hydroxy group is preferably a skeleton structure derived from the following formula (c).

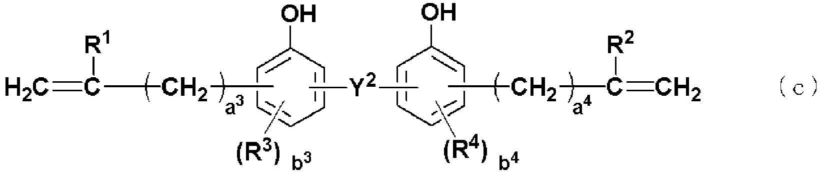

In the formula (c), Y² represents a single bond, a methylene group, a propane-2,2-diyl group, a 1,1,1,3,3,3-hexafluoropropane-2,2-diyl group, or a fluorene-9,9-diyl group; R¹ and R² each independently represent a hydrogen atom or a methyl group; R³ and R⁴ each independently represent an alkyl group having 1 to 4 carbon atoms or an alkoxy group having 1 to 4 carbon atoms; a³ and a⁴ each independently represent an integer of 0 to 7, preferably an integer of 1 to 5, more preferably an integer of 1 to 3; and b³ and b⁴ each independently represent an integer of 0 to 2, preferably 0 or 1, and more preferably 0.

The alkyl group having 1 to 4 carbon atoms may be linear, branched, or cyclic, and specific examples thereof include a methyl group, an ethyl group, a propyl group, a butyl group, and structural isomers thereof. The alkoxy group having 1 to 4 carbon atoms may be linear, branched, or cyclic, and specific examples thereof include a methoxy group, an ethoxy group, a propoxy group, a butoxy group, and structural isomers thereof.

By introducing the skeleton structure represented by the formula (c) into the surface coating layer, (A) the phenolic hydroxy group-containing silicone resin and the surface coating layer are crosslinked after exposure, so quantum dots are prevented from escaping during development, and high luminous properties of the pattern can be obtained.

In addition, by introducing the skeleton structure of formula (c) into the surface coating layer, the compatibility with (A) the phenolic hydroxy group-containing silicone resin increases, and it is possible to prevent aggregate formation when used in a photosensitive resin composition.

The amount of (C) the quantum dot to be used in the present invention is preferably 5 to 80 mass%, more preferably 10 to 70 mass% of the total amount of the photosensitive resin composition. When the content of the quantum dot particles is within the above range, it is possible to form a fine pattern while maintaining good luminous properties.

The method and amount of introducing the phenolic hydroxy group into the component (C) are not particularly limited, but when forming the phenyl group-containing siloxane, it is possible to use a method of adding and reacting a skeleton having an alkoxysilane-containing phenolic hydroxy group prepared in advance, or a method of directly introducing a skeleton having a phenolic hydroxy group by radical reaction or the like. The amount to be introduced may be adjusted appropriately, in consideration of compatibility with the resin.

### [(D) Crosslinking Agent]

The inventive photosensitive resin composition may further contain a crosslinking agent as a component (D). The crosslinking agent is a component to cause a polycondensation reaction with a phenolic hydroxy group of (A) the phenolic hydroxy group-containing silicone resin to make patterning easy, and also increases the strength of a resin film further after photocuring.

The preferable crosslinking agent are: a nitrogen-containing compound having an average two or more methylol groups and/or alkoxymethyl groups in one molecule, such as a melamine compound, a guanamine compound, a glycoluril compound, an urea compound; an amino condensate modified with formaldehyde or formaldehyde-alcohol; a phenolic compound having an average two or more methylol groups or alkoxymethyl groups in one molecule; and an epoxy compound having an average two or more epoxy groups in one molecule. One kind of compound may be used or two or more kinds thereof maybe used in combination.

The melamine compound include a compound represented by the following formula (D1).

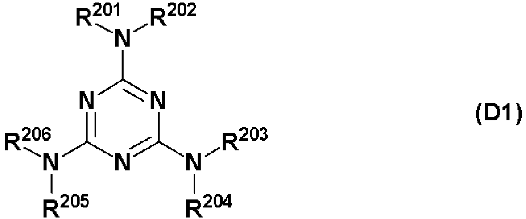

In the formula (D1), R²⁰¹ to R²⁰⁶ each independently represent a methylol group, an alkoxymethyl group having 2 to 5 carbon atoms, and a hydrogen atom, but have an average of two or more methylol groups and/or alkoxymethyl groups in one molecule. The alkoxymethyl group include a methoxymethyl group and an ethoxymethyl group.

Examples of the melamine compound represented by the formula (D1) include trimethoxymethylmonomethylolmelamine, dimethoxymethylmonomethylolmelamine, trimethylolmelamine, hexamethylolmelamine, hexamethoxymethylmelamine, and hexaethoxymethylmelamine.

The melamine compound represented by the formula (D1) can be obtained, for example, by first modifying a melamine monomer through methylolation with formaldehyde according to a publicly known method, or by modifying this compound through further alkoxylation with alcohol. The alcohol is preferably lower alcohol, for example, alcohol having 1 to 4 carbon atoms.

The guanamine compound include tetramethylolguanamine, tetramethoxymethylguanamine, and tetramethoxyethylguanamine.

The glycoluril compound include tetramethylol glycoluril, and tetrakis(methoxymethyl)glycoluril. The urea compound include tetramethylolurea, tetramethoxymethylurea, tetramethoxyethylurea, tetraethoxymethylurea, and tetrapropoxymethylurea.

The amino condensate modified with formaldehyde or formaldehyde-alcohol include melamine condensates modified with formaldehyde or formaldehyde-alcohol and urea condensates modified with formaldehyde or formaldehyde-alcohol.

The modified melamine condensates include a compound obtained by addition condensation polymerization of a compound represented by formula (D1) or a multimer thereof (for example, oligomers such as dimers and trimers) with formaldehyde until a desired molecular weight is reached. As the addition condensation polymerization, publicly conventional methods can be used. One kind of the modified melamine represented by formula (D1) may be used, or two or more kinds thereof may be used in combination.

The urea condensates modified with formaldehyde or formaldehyde-alcohol include a methoxymethylated urea condensate, an ethoxymethylated urea condensate, and a propoxymethylated urea condensate.

The modified urea condensates can be obtained, for example, by modifying a urea condensate having a desired molecular weight through methylolation with formaldehyde according to a publicly known method, or by modifying this compound through further alkoxylation with alcohol.

The phenolic compound having an average of two or more methylol groups or alkoxymethyl groups in one molecule include (2-hydroxy-5-methyl)-1,3-benzenedimethanol and 2,2',6,6'-tetramethoxymethylbisphenol A.

The epoxy compound having an average of two or more epoxy groups include: bisphenol type epoxy resins, such as a bisphenol A type epoxy resin and a bisphenol F type epoxy resin; novolac type epoxy resins, such as a phenol novolac type epoxy resin and a cresol novolac type epoxy resin; triphenolalkane type epoxy resins; biphenyl type epoxy resins; dicyclopentadiene-modified phenol novolac type epoxy resins; phenol aralkyl type epoxy resins; biphenylaralkyl type epoxy resins; naphthalene ring-containing epoxy resins; glycidyl ester type epoxy resins; alicyclic epoxy resins; and heterocyclic epoxy resins.

When contained, the component (D) is contained preferably in 0.5 to 100 parts by mass, more preferably 0.5 to 50 parts by mass, and further preferably 1 to 30 parts by mass based on 100 parts by mass of the component (A). When the component (D) is contained in 0.5 parts by mass or more, sufficient curability can be obtained by irradiation with light. One kind of the component (D) may be used, or two or more kind thereof may be used in combination.

### [(E) Solvent]

The inventive photosensitive resin composition may further contain a solvent as a component (E). The solvent is not particularly limited as long as it can dissolve each of the components mentioned above. By blending a solvent, the coatability of the photosensitive resin composition can be improved.

As the solvent, the organic solvent is preferably excellent in dissolving these components. Specific examples thereof include ketones, such as cyclohexanone, cyclopentanone, and methyl-2-n-pentyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters, such as propylene glycol monomethyl ether acetate (PGMEA), propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol-mono-tert-butyl ether acetate, and γ-butyrolactone. One kind of these solvents may be used, or two or more thereof may be used in a mixture. Particularly preferable solvents are ethyl lactate, cyclohexanone, cyclopentanone, PGMEA, γ-butyrolactone, and a mixed solvent thereof, which are excellent in dissolving the photo-acid generator.

The component (E) is preferably contained in 25 to 85 mass%, more preferably 35 to 75 mass% of the total amount of the photosensitive resin composition, from the viewpoint of compatibility and viscosity of the photosensitive resin composition.

### [Photosensitive Resin Film]

The inventive photosensitive resin film is a dried product of the photosensitive resin composition described above.

### [Patterning Process Using Photosensitive Resin Composition]

The patterning process using the inventive photosensitive resin composition includes steps of:
(i) applying the photosensitive resin composition described above onto a substrate to form a photosensitive resin film on the substrate;
(ii) exposing the photosensitive resin film to light; and
(iii) developing the exposed photosensitive resin film with a developer to dissolve and remove an unexposed portion, thereby to form a pattern.

The step (i) is a step in which the photosensitive resin composition is applied onto a substrate to form a photosensitive resin film on the substrate. Examples of the substrate include a silicon wafer, a glass wafer, a quartz wafer, and a micro LED laminate substrate.

The application method may be a publicly known method, and the examples thereof include a dipping method, a spin-coating method, and a roll-coating method. The amount to be applied can be appropriately selected in accordance with the purpose, but the application is performed so that the obtained photosensitive resin film have preferably a thickness of 0.1 to 200 µm, more preferably 1 to 150 µm.

To enhance the film thickness uniformity on a substrate surface, a solvent may be dropped on the substrate before the photosensitive resin composition is applied (pre-wetting method). The solvent to be dropped can be appropriately selected in accordance with the purpose. Preferable examples of the solvent include alcohols, such as isopropyl alcohol (IPA); ketones, such as cyclohexanone; glycols, such as propylene glycol monomethyl ether; etc. It is also possible to use the solvent used for the photosensitive resin composition.

In this case, the solvent or the like may be preliminary evaporated by pre-heating (pre-baking) as necessary for efficient photocuring reaction. The pre-baking may be performed, for example, at 40 to 140°C for about 1 minute to 1 hour.

Then, (ii) the photosensitive resin film is exposed to light. In this event, the exposure is preferably performed with light having a wavelength of 10 to 600 nm, more preferably performed with light having a wavelength of 190 to 500 nm. The light having such wavelengths are, for example, light having various wavelengths generated from a radiation-beam generating instrument. Examples of the light include ultraviolet light, such as a g-line, an h-line, and an i-line; and far ultraviolet light (248 nm, 193 nm). Among these, light with a wavelength of 248 to 436 nm is particularly preferable. The exposure dose is preferably 10 to 10,000 mJ/cm².

The exposure may be performed via a photomask. The photomask may have a desired pattern by boring, for example. Note that materials of the photomask are not particularly limited, but are preferably those blocks light with the aforementioned wavelength. For example, a photomask having a light-blocking film containing chromium is suitably used, but is not limited thereto.

Further, in order to enhance the development sensitivity, the post-exposure baking (PEB) may be carried out. The PEB is preferably performed at 40 to 150°C for 0.5 to 20 minutes. PEB makes the exposed part crosslinked to form an insoluble pattern that is insoluble in an organic solvent, which is a developer. The dried product is the photosensitive resin composition in a status in which the solvents have been removed after the pre-baking.

(iii) The exposed photosensitive resin film is developed with a developer after the exposure or PEB, so that an unexposed portion is dissolved and removed to form a pattern. The developer is preferably an organic solvent. Examples thereof include alcohols, such as IPA; ketones, such as cyclohexanone; glycols, such as propylene glycol monomethyl ether. It is also possible to use the solvent used for the photosensitive resin composition. Examples of the development method include usual methods, such as a method in which the patterned substrate is soaked into the developer. Then, if necessary, washing, rinsing, drying, and so forth are carried out to obtain a film having a desired pattern.

Further, the patterned film may be post-cured using an oven or a hot plate, preferably at 100 to 200°C.

### [Photosensitive Dry Film]

The inventive photosensitive dry film includes: a support film; and a photosensitive resin film, which is obtained from the photosensitive resin composition, on the support film.

The photosensitive dry film (the support film and the photosensitive resin film) is solid, and the photosensitive resin film does not contain a solvent. Accordingly, bubbles due to the volatilization of the solvent will not remain in the photosensitive resin film and between this film and a substrate having asperities. The thickness of the photosensitive resin film is not particularly limited, but is preferably 1 to 200 µm, more preferably 3 to 100 µm.

In addition, the viscosity and fluidity of the photosensitive resin film are closely related. The photosensitive resin film can exhibit appropriate fluidity in an appropriate viscosity range, and the photosensitive resin film enters deeply into a narrow gap and the resin softens, so that the adhesion to a substrate can be enhanced. Thus, the photosensitive resin film preferably has a viscosity of 10 to 5,000 Pa·s, more preferably 30 to 2,000 Pa·s, further preferably 50 to 300 Pa·s, at 80 to 120°C from the viewpoint of the fluidity of the photosensitive resin film. Incidentally, in the present invention, the viscosity is a value measured with a rotational viscometer.

When the inventive photosensitive dry film is brought into close contact with a substrate having asperities, the photosensitive resin film fits in and covers the asperities, so that high flatness can be achieved. Particularly, the inventive photosensitive resin composition is characterized by softening performance so that higher planarization can be achieved. Further, bringing the photosensitive resin film into close contact with the substrate under vacuum environment makes it possible to prevent the occurrence of such a gap therebetween more effectively.

The inventive photosensitive dry film can be manufactured by applying the photosensitive resin composition onto a base material, and drying the composition to form a photosensitive resin film. As the manufacturing apparatus for the photosensitive dry film, it is possible to employ a film coater that is commonly used to manufacture adhesive products. Examples of the film coater include a comma coater, a comma reverse coater, a multi coater, a die coater, a lip coater, a lip reverse coater, a die coater, a lip coater, a lip reverse coater, a direct gravure coater, an offset gravure coater, a 3-roll bottom reverse coater, and a 4-roll bottom reverse coater.

When the support film is rolled-out from a roll-out shaft of the film coater and passes through a coater head of the film coater, the photosensitive resin composition is applied onto the support film to have a predetermined thickness; then, the resultant is passed through a hot-air circulating oven at a predetermined temperature for a predetermined period to dry on the support film and form the photosensitive resin film, so that the photosensitive dry film can be manufactured. It is also possible to manufacture the photosensitive dry film with a protective film in accordance with need by: passing the photosensitive dry film through a laminate roll under a predetermined pressure together with the protective film that has been rolled-out from another roll-out shaft of the film coater, thereby bonding the protective film to the photosensitive resin film on the support film; and subsequently winding up the resulting laminate to a winding shaft of the film coater. In this case, the temperature is preferably 25 to 150°C, the period is preferably 1 to 100 minutes, and the pressure is preferably of 0.01 to 5 MPa.

The support film used in the inventive photosensitive dry film may be a monolayer film composed of a single film or a multilayer film composed of multiple laminated films. Examples of the material of the film include synthetic resin films, such as polyethylene, polypropylene, polycarbonate, and polyethylene terephthalate. Among these, preferable is polyethylene terephthalate having appropriate flexibility, mechanical strength, and heat resistance. These films may have been subjected to various treatments, such as corona treatment and coating treatment with a releasing agent. Commercial products may be used for these. Examples thereof include Cerapeel WZ (RX) and Cerapeel BX8 (R) (both are manufactured by Toray Advanced Film Co., Ltd.), E7302 and E7304 (both are manufactured by Toyobo Co., Ltd.), Purex G31 and Purex G71T1 (both are manufactured by Teijin DuPont Films Japan Ltd.), PET38×1-A3, PET38×1-V8, and PET38×1-X08 (all manufactured by Nippa Co., Ltd.).

The protective film to be used may be the same film as the above-mentioned support film, but polyethylene terephthalate and polyethylene having appropriate flexibility are preferable. Commercial products may be used for these. Examples thereof include the polyethylene terephthalates that have already been exemplified; and polyethylenes, such as GF-8 (manufactured by Tamapoly Co., Ltd.) and PE Film 0-Type (manufactured by Nippa Co., Ltd.).

The thicknesses of both the support film and the protective film are preferably 10 to 100 µm, more preferably 25 to 50 µm, from the viewpoints of stable production of the photosensitive dry film and prevention of film formation in a curled shape around a roll shaft, which is called "curl-prevention".

### [Patterning Process Using Photosensitive Dry Film]

The patterning process, which uses the inventive photosensitive dry film, includes steps of:
(i') sticking the photosensitive resin film of the photosensitive dry film described above onto a substrate to form a photosensitive resin film on the substrate;
(ii) exposing the photosensitive resin film to light; and
(iii) developing the exposed photosensitive resin film with a developer to dissolve and remove an unexposed portion, thereby to form a pattern.

First, (i') the photosensitive dry film is used to form the photosensitive resin film on a substrate by sticking the photosensitive resin film onto a substrate. Specifically, the photosensitive resin film of the photosensitive dry film is sticked to a substrate, so that the photosensitive resin film is formed on the substrate. Meanwhile, in the case where the photosensitive dry film has a protective film, after the protective film is peeled off from the photosensitive dry film, the photosensitive resin film of the photosensitive dry film is sticked to the substrate. The sticking can be performed, for example, by using a film-sticking apparatus.

The film-sticking apparatus is preferably a vacuum laminator. For example, the protective film of the photosensitive dry film is delaminated, and the uncovered photosensitive resin film is brought into close contact with the substrate on a table at a predetermined temperature by using a sticking roll under a predetermined pressure in a vacuum chamber with a predetermined degree of vacuum. The temperature is preferably 60 to 120°C, the pressure is preferably 0 to 5.0 MPa, and the degree of vacuum is preferably 50 to 500 Pa.

For efficient photocuring reaction of the photosensitive resin film and improving adhesiveness between the photosensitive resin film and the substrate, pre-baking may be performed as necessary. The pre-baking can be performed, for example, at 40 to 140°C for about 1 minute to 1 hour.

The photosensitive resin film sticked on the substrate can be subjected to the step (ii) exposing the photosensitive resin film to light, the step (iii) developing the exposed photosensitive resin film with a developer to dissolve and remove an unexposed portion for patterning, and as necessary the step (iv) heating treatment for post-curing, to form a pattern as in the case of the patterning process using the photosensitive resin composition. Incidentally, the support film of the photosensitive dry film is delaminated or removed by other methods before the pre-baking or before the PEB, depending on the process.

The patterning processes using the inventive photosensitive resin composition or photosensitive dry film make it possible to easily form a fine pattern. For example, light in red and green can be emitted thanks to forming a cured film containing red quantum dots and green quantum dots in each segment on a blue micro-LED by: forming a film by using the inventive photosensitive resin composition or a photosensitive dry film so that the film covers numerous blue micro-LEDs paving a substrate; and next performing a fine patterning. These enable to production of a light emitting device capable of emitting full color.

### [Light Emitting Device]

The inventive light emitting device includes a cured film obtained by the patterning process described above.

### EXAMPLE

Hereinafter, the present invention will be specifically described with reference to Synthesis Examples, Examples, and Comparative Examples. However, the present invention is not limited thereto. Incidentally, a quantum dot of an InP/ZnSe/ZnS core-shell type was used as a quantum dot material. The synthesis methods for the core are as shown below in [1-1] (red quantum dot) and [1-2] (green quantum dot), and the subsequent synthesis method for the shell is as shown in [2].

### [1-1] Synthesis Process of Red Quantum Dot Core

Two flasks were prepared, and 0.23 g (0.9 mmol) of palmitic acid, 0.088 g (0.3 mmol) of indium acetate, and 10 mL of 1-octadecene were added to each flask. The mixture was heated and stirred at 100°C under reduced pressure, and degassed for 1 hour while dissolving the materials. Nitrogen was then purged into the two flasks, and 0.75 mL (0.15 mmol) of tristrimethylsilylphosphine/trioctylphosphine solution (0.2 M) was added to both flasks. One of the flasks was then heated to 300°C, and the solution was removed from the flask that had not been heated and added to the flask that had been heated to 300°C, thereby to produce core particles.

### [1-2] Synthesis Process of Green Quantum Dot Core

0.23 g (0.9 mmol) of palmitic acid, 0.088 g (0.3 mmol) of indium acetate, and 10 mL of 1-octadecene were added to a flask, and the mixture was heated and stirred at 100°C under reduced pressure, and degassed for 1 hour while dissolving the materials. Nitrogen was then purged into the flask, and 0.75 mL (0.15 mmol) of a solution prepared by mixing tristrimethylsilylphosphine with trioctylphosphine to give a 0.2 M solution was added, and the temperature was raised to 300°C to produce core particles.

### [2] Synthesis Process of Quantum Dot Shell

Next, 2.85 g (4.5 mmol) of zinc stearate and 15 mL of 1-octadecene were added to another flask, and the mixture was heated and stirred at 100°C under reduced pressure, and degassed for 1 hour while dissolving the zinc stearate to prepare a 0.3 M zinc stearate octadecene solution. 3.0 mL (0.9 mmol) of the solution was added to the reaction solution after the core synthesis process, and the solution was cooled to 200°C. Next, 0.474 g (6 mmol) of selenium and 4 mL of trioctylphosphine were added to another flask, and the mixture was heated to 150°C for dissolving to prepare a 1.5 M selenium trioctylphosphine solution. While heating the reaction solution after the core synthesis process, which had been cooled to 200°C, to 320°C over 30 minutes, the mixture was added with the selenium trioctylphosphine solution in 0.1 mL increments to a total of 0.6 mL (0.9 mmol), maintained at 320°C for 10 minutes, and then cooled to room temperature. 0.44 g (2.2 mmol) of zinc acetate was added to the mixture and dissolved by heating and stirring at 100°C under reduced pressure. The flask was purged again with nitrogen and heated to 230°C, and added with 0.98 mL (4 mmol) of 1-dodecanethiol and held for 1 hour. The resulting solution was cooled to room temperature to prepare a solution containing core-shell type quantum dots. The red core-shell type quantum dot synthesized through the processes from [1-1] to [2] is designated R-1, and the green core-shell type quantum dot-containing solution synthesized through the processes from [1-2] to [2] is designated G-1.

### [3] Process of Replacing Ligand

(3-mercaptopropyl)triethoxysilane was used as a ligand having a substituent capable of forming a siloxane bond and a substituent coordinated to the surface of a quantum dot. For the ligand exchange reaction, (3-mercaptopropyl)triethoxysilane (3.0 mmol) was added to the solution after the shell synthesis process that had been cooled to room temperature, and the solution was stirred for 24 hours. After the reaction was completed, ethanol was added to make precipitate in the reaction solution, which was then centrifuged to remove the supernatant. The same purification process was repeated again, and the resultant was dispersed in toluene to produce a solution of a quantum dot in which ligands having a substituent capable of forming a siloxane bond were coordinated. The quantum dot having the ligand having a substituent capable of forming a siloxane bond synthesized using R-1, was designated R-2, and the quantum dot having the ligand having a substituent capable of forming a siloxane bond synthesized using G-1, was designated G-2.

### [4-1] Process of Forming Surface Coating Layer

Triethoxysilylpropyl methacrylate (4.0 mmol), diphenylsilanediol (6 mmol), barium hydroxide monohydrate (0.15 mmol), and the solution of a quantum dot in toluene after the process of replacing a ligand were added to a flask that had been purged with nitrogen, and the mixture was heated and stirred at 65°C for 24 hours. After the reaction was completed, the mixture was cooled to room temperature; ethanol was added to make precipitate in the reaction solution; the solution was centrifuged; and the supernatant was removed. The precipitate was dispersed in toluene and the dispersion was added to a flask that had been purged with nitrogen in advance, and 2 parts by mass of the compound represented by the following formula (1) was added thereto based on 100 parts by mass of the quantum dot toluene solution. Furthermore, 1 part by mass of Irgacure 1173 was added thereto based on 100 parts by mass of the compound represented by the following formula (1); the mixture was mixed and stirred; and then the mixture was irradiated with light having a wavelength of 365 nm and an output of 4000 mW/cm² for 20 seconds using a UVLED irradiation apparatus. After the reaction was completed, ethanol was added to cause precipitation, and the supernatant after centrifugation was removed and the precipitate was dispersed in toluene again. Then, PGMEA was added thereto, and the toluene solvent was removed by distillation under reduced pressure. Thus, a solution (solution with a solid content of 60%) of a quantum dot having a surface coating layer formed was prepared. Here, the quantum dot in which the surface coating layer was formed based on R-2 was designated R-(1), and the quantum dot in which the surface coating layer was formed based on G-2 was designated G-(1).

### [4-2] Process of Forming Surface Coating Layer

Triethoxysilylpropyl methacrylate (4.0 mmol), diphenylsilanediol (6 mmol), barium hydroxide monohydrate (0.15 mmol), and the solution of a quantum dot in toluene after the process of replacing a ligand were added to a flask that had been purged with nitrogen, and the mixture was heated and stirred at 65°C for 24 hours. After the reaction was completed, the mixture was cooled to room temperature; ethanol was added to make precipitate in the reaction solution; the solution was centrifuged; and the supernatant was removed. The precipitate was dispersed in toluene and the dispersion was added to a flask that had been purged with nitrogen in advance, and 2 parts by mass of the compound represented by the following formula (1') was added thereto based on 100 parts by mass of the quantum dot toluene solution. Furthermore, 1 part by mass of Irgacure 1173 was added thereto based on 100 parts by mass of the compound represented by the following formula (1'); the mixture was mixed and stirred; and then the mixture was irradiated with light having a wavelength of 365 nm and an output of 4000 mW/cm² for 20 seconds using a UVLED irradiation apparatus. After the reaction was completed, ethanol was added to cause precipitation, and the supernatant after centrifugation was removed and the precipitate was dispersed in toluene again. Then, PGMEA was added thereto, and the toluene solvent was removed by distillation under reduced pressure. Thus, a solution (solution with a solid content of 60%) of a quantum dot having a surface coating layer formed was prepared. Here, the quantum dot in which the surface coating layer was formed based on R-2 was designated R-(1'), and the quantum dot in which the surface coating layer was formed based on G-2 was designated G-(1').

### [5] Synthesis of Silicone Resin

### [Synthesis Example 1] Synthesis of Resin 1

Into a 3-L flask equipped with a stirrer, a thermometer, a nitrogen purging device, and a reflux condenser, 215.0 g (0.50 mol) of Compound (1) was added; then, 2,000 g of toluene was added thereto; and the mixture was heated to 70°C. Subsequently, 1.0 g of toluene solution of chloroplatinic acid (platinum concentration: 0.5 mass%) was introduced, and 58.2 g (0.30 mol) of Compound (2) and 604.0 g (0.20 mol) of Compound (4) were added dropwise over 1 hour (total of hydrosilyl groups/total of alkenyl groups=1/1 (mole ratio)). After completion of the dropwise addition, the mixture was heated to 100°C and aged for 6 hours. Thereafter, toluene was evaporated from the reaction solution under reduced pressure. Thus, Resin 1 was obtained. By GPC measurement, it was confirmed that the peaks of the materials were each disappeared and that Resin 1 had an Mw of 80,000 (a silicone content percentage of 68.9 mass%, which was calculated from charging amounts).

### [Synthesis Example 2] Synthesis of Resin 2

Into a 3-L flask equipped with a stirrer, a thermometer, a nitrogen purging device, and a reflux condenser, 215.0 g (0.50 mol) of Compound (1) was added; then, 2,000 g of toluene was added thereto; and the mixture was heated to 70°C. Subsequently, 1.0 g of toluene solution of chloroplatinic acid (platinum concentration: 0.5 mass%) was introduced, and 67.9 g (0.35 mol) of Compound (2), 6.7 g (0.05 mol) of Compound (3), and 302.0 g (0.10 mol) of Compound (4) were added dropwise over 1 hour (total of hydrosilyl groups/total of alkenyl groups=1/1 (mole ratio)). After completion of the dropwise addition, the mixture was heated to 100°C and aged for 6 hours. Thereafter, toluene was evaporated from the reaction solution under reduced pressure. Thus, Resin 2 was obtained. By GPC measurement, it was confirmed that the peaks of the materials were each disappeared and that Resin 2 had an Mw of 40,000 (a silicone content percentage of 52.2 mass%).

### [Synthesis Example 3] Synthesis of Resin 3

Into a 3-L flask equipped with a stirrer, a thermometer, a nitrogen purging device, and a reflux condenser, 215.0 g (0.50 mol) of Compound (1) was added; then, 2,000 g of toluene was added thereto; and the mixture was heated to 70°C. Subsequently, 1.0 g of toluene solution of chloroplatinic acid (platinum concentration: 0.5 mass%) was introduced, and 87.3 g (0.45 mol) of Compound (2), 6.7 g (0.05 mol) of Compound (3), and 151.0 g (0.05 mol) of Compound (4) were added dropwise over 1 hour (total of hydrosilyl groups/total of alkenyl groups=1/1 (mole ratio)). After completion of the dropwise addition, the mixture was heated to 100°C and aged for 6 hours. Thereafter, toluene was evaporated from the reaction solution under reduced pressure. Thus, Resin 2 was obtained. By GPC measurement, it was confirmed that the peaks of the materials were each disappeared and that Resin 3 had an Mw of 13,000 (a silicone content percentage of 34.3 mass%).

The compounds (1) to (4) used in the above synthesis examples are as follows.

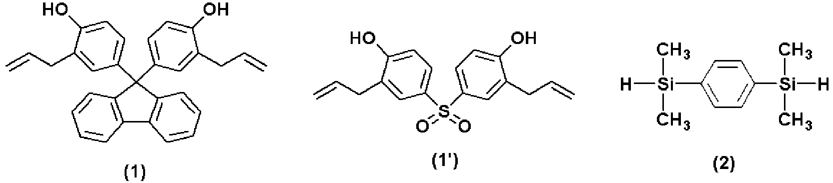

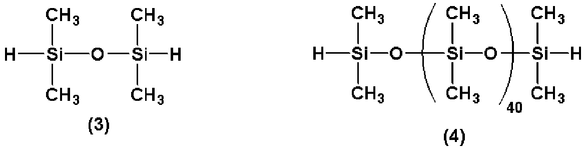

### [6] Preparation and Evaluation of Photosensitive Resin Composition

### [Examples 1 to 12 and Comparative Examples 1 to 24]

Each component was blended according to the blending amounts shown in Tables 1 to 4, then the mixture was mixed and stirred at room temperature, and microfiltered through a 1.0 µm glass filter to obtain the photosensitive resin compositions of Examples 1 to 12 and Comparative Examples 1 to 24.

**[Table 1]**

| Component | | | Example | | | | | |
|---|---|---|---|---|---|---|---|---|
| | | | 1 | 2 | 3 | 4 | 5 | 6 |
| A | Silicone Resin | Resin 1 | 100 | | | 100 | | |
| | | Resin 2 | | 100 | | | 100 | |
| | | Resin 3 | | | 100 | | | 100 |
| B | Photo-acid generator | B-1 | 2 | | 20 | 2 | | 20 |
| | | B-2 | | 10 | 20 | | 10 | 20 |
| C | Quantum dot | R-(1) | 15 | 100 | 350 | | | |
| | | R- (1') | | | | 15 | 100 | 350 |
| D | Crosslinking agent | D-1 | 1 | 5 | | 1 | 5 | |
| | | D-2 | | 5 | 30 | | 5 | 30 |
| E | Solvent | Cyclopentanone | 118 | 220 | 520 | 118 | 220 | 520 |

**[Table 2]**

| Component | | | Example | | | | | |
|---|---|---|---|---|---|---|---|---|
| | | | 7 | 8 | 9 | 10 | 11 | 12 |
| A | Silicone Resin | Resin 1 | 100 | | | 100 | | |
| | | Resin 2 | | 100 | | | 100 | |
| | | Resin 3 | | | 100 | | | 100 |
| B | Photo-acid generator | B-1 | 2 | | 20 | 2 | | 20 |
| | | B-2 | | 10 | 20 | | 10 | 20 |
| C | Quantum dot | G-(1) | 15 | 100 | 350 | | | |
| | | G-(1') | | | | 15 | 100 | 350 |
| D | Crosslinking agent | D-1 | 1 | 5 | | 1 | 5 | |
| | | D-2 | | 5 | 30 | | 5 | 30 |
| E | Solvent | Cyclopentanone | 118 | 220 | 520 | 118 | 220 | 520 |

**[Table 3]**

| Component | | | Comparative Example | | | | | | | | | | | |
|---|---|---|---|---|---|---|---|---|---|---|---|---|---|---|
| | | | 1 | 2 | 3 | 4 | 5 | 6 | 7 | 8 | 9 | 10 | 11 | 12 |
| A | Silicone Resin | Resin 1 | 100 | | | 100 | | | 100 | | | 100 | | |
| | | Resin 2 | | 100 | | | 100 | | | 100 | | | 100 | |
| | | Resin 3 | | | 100 | | | 100 | | | 100 | | | 100 |
| B | Photo-acid generator | B-1 | 2 | | 20 | 2 | | 20 | 2 | | 20 | 2 | | 20 |
| | | B-2 | | 10 | 20 | | 10 | 20 | | 10 | 20 | | 10 | 20 |
| C | Quantum dot | R-1 | 15 | 100 | 350 | | | | | | | | | |
| | | R-2 | | | | 15 | 100 | 350 | | | | | | |
| | | R-3 | | | | | | | 15 | 100 | 350 | | | |
| | | R-4 | | | | | | | | | | 15 | 100 | 350 |
| D | Crosslinking agent | D-1 | 1 | 5 | | 1 | 5 | | 1 | 5 | | 1 | 5 | |
| | | D-2 | | 5 | 30 | | 5 | 30 | | 5 | 30 | | 5 | 30 |
| E | Solvent | Cyclo pentanone | 118 | 220 | 520 | 118 | 220 | 520 | 118 | 220 | 520 | 118 | 220 | 520 |

**[Table 4]**

| Component | | | Comparative Example | | | | | | | | | | | |
|---|---|---|---|---|---|---|---|---|---|---|---|---|---|---|
| | | | 13 | 14 | 15 | 16 | 17 | 18 | 19 | 20 | 21 | 22 | 23 | 24 |
| A | Silicone Resin | Resin 1 | 100 | | | 100 | | | 100 | | | 100 | | |
| | | Resin 2 | | 100 | | | 100 | | | 100 | | | 100 | |
| | | Resin 3 | | | 100 | | | 100 | | | 100 | | | 100 |
| B | Photo-acid generator | B-1 | 2 | | 20 | 2 | | 20 | 2 | | 20 | 2 | | 20 |
| | | B-2 | | 10 | 20 | | 10 | 20 | | 10 | 20 | | 10 | 20 |
| C | Quantum dot | G-1 | 15 | 100 | 350 | | | | | | | | | |
| | | G-2 | | | | 15 | 100 | 350 | | | | | | |
| | | G-3 | | | | | | | 15 | 100 | 350 | | | |
| | | G-4 | | | | | | | | | | 15 | 100 | 350 |
| D | Crosslinking agent | D-1 | 1 | 5 | | 1 | 5 | | 1 | 5 | | 1 | 5 | |
| | | D-2 | | 5 | 30 | | 5 | 30 | | 5 | 30 | | 5 | 30 |
| E | Solvent | Cyclo pentanone | 118 | 220 | 520 | 118 | 220 | 520 | 118 | 220 | 520 | 118 | 220 | 520 |

In Tables 1 to 4, the used photo-acid generators B-1 and B-2 are as follows.

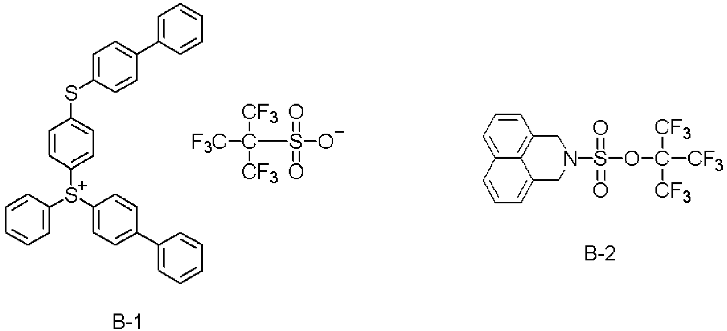

In Tables 1 to 4, the used crosslinking agents D-1 and D-2 are as follows.

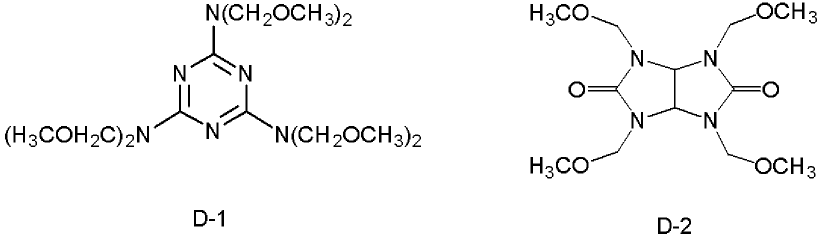

In Tables 1 to 4, the quantum dot R-3 is S-BE030 manufactured by Shoei Chemical Inc. (particle size: 5 to 10 nm, material: InP:ZnS:SeZn = 25:50:25), R-4 is 900514-1ML manufactured by Aldrich (particle size: 5 to 10 nm, material: CdSe (core) / CdS (shell) core-shell type), G-3 is S-BE029 manufactured by Shoei Chemical Inc. (particle size: 3 to 5 nm, material: InP:ZnS:SeZn = 25:50:25), and G-4 is 900511-1ML manufactured by Aldrich (particle size: 3 to 5 nm, material: CdSe (core) / CdS (shell) core-shell type).

### [7] Preparation of Photosensitive Dry Film

Using a die coater as a film coater and a polyethylene terephthalate film (thickness 38 µm) as a support film, the photosensitive resin compositions shown in Tables 1 to 4 each were applied onto the support film. Then, the composition was dried by passing through a hot air circulating oven (length 4 m) set at 100°C for 5 minutes, and a photosensitive resin film was formed on the support film so that the film had a thickness of 20 µm to obtain a photosensitive dry film. A polyethylene film (thickness 50 µm) was laminated as a protective film on the photosensitive resin film at a pressure of 1 MPa using a laminating roll to prepare a photosensitive dry film with a protective film.

### [8] Evaluation of Photosensitive Resin Film

### (1) Checking Presence of Aggregate in Photosensitive Resin Film

The protective film was peeled off from the photosensitive dry film with a protective film, and presence of the aggregates in the photosensitive dry film was checked with an optical microscope. A sample having aggregate with a size of 1 µm or more was judged "Bad", and a sample having no aggregate or aggregate with a size of less than 1 µm was judged "Good". The results are shown in Tables 5 to 8.

### (2) Formation and Evaluation of Pattern

In case of the photosensitive dry film with a protective film, the protective film was peeled off, and a photosensitive resin film on a support film was brought into close contact with a silicon wafer using a vacuum laminator TEAM-100RF (manufactured by Takatori Co., Ltd.) with setting the degree of vacuum in a vacuum chamber at 80 Pa. The temperature condition was 100°C. After returning to normal pressure, the substrate was removed from the vacuum laminator, and the support film was peeled off. Next, in order to increase the adhesiveness to the substrate, pre-baking was performed on a hot plate at 110°C for 3 minutes. Using an i-line stepper NSR-2205i11D (manufactured by Nikon Corporation), the obtained photosensitive resin film was exposed to light through a mask to form a square island pattern having a pitch distance of 1:1 to an adjacent pattern using a mask. After exposure, the film was subjected to PEB on a hot plate at 120°C for 3 minutes, and then cooled, and the substrate was spray-developed with PGMEA for 60 seconds to form a pattern.
Thereafter, the substrate was post-cured in an oven at 150°C for 2 hours while purging with nitrogen. Then, the formed island patterns having a side of 100 µm, 50 µm, 30 µm, 20 µm, and 10 µm were observed with a scanning electron microscope (SEM), and the size of the smallest pattern that was not connected to the adjacent island pattern (pitch distance 1:1) was defined as limit resolution. When the resolution of a sample did not reach 100 µm or the pattern of a sample was peeled off during development, the sample was judged as "Bad". The results are shown in Tables 5 to 8.

### (3) Evaluation of Luminous Properties of Formed Pattern

Using LabRAM HR Evolution manufactured by Horiba Techno Service Co., Ltd., the patterned sample prepared in (2) above was irradiated with laser beam (0.03 mW) having a wavelength of 457 nm, the photoconverted island pattern area was measured for emission intensity, emission wavelength, and half band width of the photoconverted light. In addition, the sample prepared in (2) above after the lamination and support film peeling was similarly measured for the emission intensity of the photoconverted light. The results are shown in Tables 5 to 8 (M represents 1 million).

### (4) Evaluation of Reliability

A glass substrate was coated with the photosensitive resin composition shown in Tables 1 to 4 at a film thickness of 100 µm using a spin coater. In order to remove the solvent from the composition, the substrate was placed on a hot plate and dried by heating at 110°C for 20 minutes. The obtained photosensitive resin film was exposed to light through a mask using a contact aligner type exposure apparatus under exposure conditions of 365 nm in order to form a square island pattern having a side of 1 cm. After irradiation, The film was subjected to PEB on a hot plate at 140°C for 5 minutes and then cooled, and the substrate was spray-developed with PGMEA for 300 seconds to form a pattern. Then, the substrate was post-cured in an oven at 150°C for 2 hours while purging with nitrogen. The patterned sample was subjected to a heat cycle test (1,000 cycles of holding at -55°C for 10 minutes and at 125°C for 10 minutes), and peeling status of the cured film from the substrate and the presence or absence of cracks after the heat cycle test were checked. Those that showed no peeling or cracking were judged as "Good", and those that showed even one peeling or cracking were judged as "Bad". The results are shown in Tables 5 to 8.

**[Table 5]**

| | | Example | | | | | |
|---|---|---|---|---|---|---|---|
| | | 1 | 2 | 3 | 4 | 5 | 6 |
| Checking Presence of Aggregate | | Good | Good | Good | Good | Good | Good |
| Limit resolution of patterning / µm | | 10 | 10 | 20 | 10 | 10 | 20 |
| Emission intensity after lamination | | 21M | 73M | 107M | 20M | 72M | 105M |
| Luminous properties of pattern in cured film | Wavelength / µm | 624 | 627 | 629 | 626 | 629 | 630 |
| | Half band width / nm | 42 | 44 | 47 | 43 | 46 | 48 |
| | Emission intensity | 21M | 73M | 107M | 20M | 72M | 105M |
| Crack / Peeling after reliability test | | Good | Good | Good | Good | Good | Good |

**[Table 6]**

| | | Example | | | | | |
|---|---|---|---|---|---|---|---|
| | | 7 | 8 | 9 | 10 | 11 | 12 |
| Checking Presence of Aggregate | | Good | Good | Good | Good | Good | Good |
| Limit resolution of patterning / µm | | 10 | 10 | 20 | 10 | 10 | 20 |
| Emission intensity after lamination | | 17M | 59M | 88M | 16M | 58M | 86M |
| Luminous properties of pattern in cured film | Wavelength / µm | 534 | 537 | 539 | 536 | 538 | 540 |
| | Half band width / nm | 37 | 40 | 42 | 38 | 42 | 43 |
| | Emission intensity | 17M | 59M | 88M | 16M | 58M | 86M |
| Crack / Peeling after reliability test | | Good | Good | Good | Good | Good | Good |

**[Table 7]**

| | | Comparative Example | | | | | | | | | | | |
|---|---|---|---|---|---|---|---|---|---|---|---|---|---|
| | | 1 | 2 | 3 | 4 | 5 | 6 | 7 | 8 | 9 | 10 | 11 | 12 |
| Checking Presence of Aggregate | | Bad | Bad | Bad | Bad | Bad | Bad | Bad | Bad | Bad | Bad | Bad | Bad |
| Limit resolution of patterning / µm | | 100 | 100 | Bad | 100 | 100 | Bad | 100 | 100 | Bad | 100 | 100 | Bad |
| Emission intensity after lamination | | 10M | 36M | 54M | 9M | 35M | 54M | 11M | 35M | 53M | 10M | 34M | 53M |
| Luminous properties of pattern in cured film | Wavelength / µm | 636 | 638 | 640 | 637 | 639 | 641 | 636 | 637 | 640 | 635 | 638 | 639 |
| | Half band width / nm | 53 | 55 | 57 | 52 | 54 | 56 | 53 | 56 | 57 | 55 | 55 | 58 |
| | Emission intensity | 6M | 20M | 30M | 5M | 18M | 29M | 6M | 21M | 32M | 6M | 21M | 31M |
| Crack / Peeling after reliability test | | Bad | Bad | Bad | Bad | Bad | Bad | Bad | Bad | Bad | Bad | Bad | Bad |

**[Table 8]**

| | | Comparative Example | | | | | | | | | | | |
|---|---|---|---|---|---|---|---|---|---|---|---|---|---|
| | | 13 | 14 | 15 | 16 | 17 | 18 | 19 | 20 | 21 | 22 | 23 | 24 |
| Checking Presence of Aggregate | | Bad | Bad | Bad | Bad | Bad | Bad | Bad | Bad | Bad | Bad | Bad | Bad |
| Limit resolution of patterning / µm | | 100 | 100 | Bad | 100 | 100 | Bad | 100 | 100 | Bad | 100 | 100 | Bad |
| Emission intensity after lamination | | 9M | 30M | 45M | 9M | 31M | 46M | 10M | 30M | 47M | 9M | 31M | 46M |
| Luminous properties of pattern in cured film | Wavelength / µm | 541 | 544 | 548 | 542 | 545 | 548 | 543 | 544 | 549 | 541 | 543 | 548 |
| | Half band width / nm | 53 | 56 | 59 | 54 | 57 | 60 | 53 | 55 | 59 | 52 | 56 | 58 |
| | Emission intensity | 5M | 15M | 28M | 4M | 16M | 25M | 5M | 14M | 23M | 4M | 15M | 24M |
| Crack / Peeling after reliability test | | Bad | Bad | Bad | Bad | Bad | Bad | Bad | Bad | Bad | Bad | Bad | Bad |

From the above results, it was shown that the inventive photosensitive resin composition can form a good photosensitive film or a photosensitive dry film having no aggregate (or having very small aggregates if any), has high lithography resolution, high luminous properties that do not change before and after the lithography process, has good reliability (adhesiveness, crack resistance), and can provide a cured film suitable for a light emitting device.

The present description includes the following embodiments.
[1]: A photosensitive resin composition comprising:
   (A) a phenolic hydroxy group-containing silicone resin;
   (B) a photo-acid generator; and
   (C) a quantum dot, wherein
   the quantum dot has a surface coating layer containing siloxane.
[2]: The photosensitive resin composition of the above [1], wherein the component (C) has a skeleton having a phenolic hydroxy group in the surface coating layer.
[3]: The photosensitive resin composition of the above [1] or [2], wherein the component (A) has a repeating unit represented by the following formula (a1) and a repeating unit represented by the formula (b1), 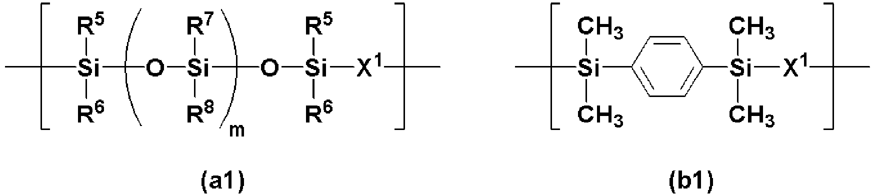 wherein R⁵ to R⁸ each independently represent a monovalent hydrocarbon group having 1 to 8 carbon atoms; "m" represents an integer of 0 to 600; and X¹ represents a divalent group represented by the following formula (X1), 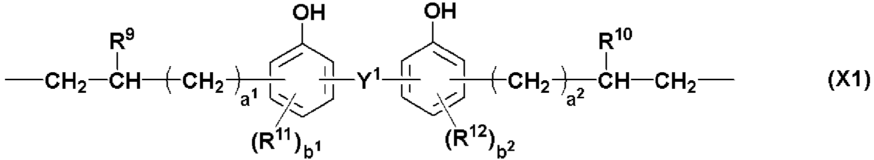 wherein, Y¹ represents a single bond, a methylene group, a propane-2,2-diyl group, a 1,1,1,3,3,3-hexafluoropropane-2,2-diyl group, or a fluorene-9,9-diyl group; R⁹ and R¹⁰ each independently represent a hydrogen atom or a methyl group; R¹¹ and R¹² each independently represent an alkyl group having 1 to 4 carbon atoms or an alkoxy group having 1 to 4 carbon atoms; a¹ and a² each independently represent an integer of 0 to 7; and b¹ and b² each independently represent an integer of 0 to 2.
[4]: The photosensitive resin composition of the above [1], [2], or [3], further comprising at least one crosslinking agent selected from the group consisting of a melamine compound, a guanamine compound, a glycoluril compound, and a urea compound, which have an average of two or more methylol groups, an average of two or more alkoxymethyl groups, or both thereof per molecule, amino condensates modified with formaldehyde or formaldehyde-alcohol, and phenol compounds having an average of two or more methylol groups or alkoxymethyl groups per molecule, as the component (D).
[5]: The photosensitive resin composition of the above [1], [2], [3], or [4], wherein the quantum dot as the component (C) has a ligand coordinated on the surface, the surface coating layer has a siloxane bond bonded to the ligand, and a substituent of the ligand has any one or more kinds of an amino group, a thiol group, a carboxy group, a phosphino group, a phosphine oxide group, or an ammonium ion.
[6]: The photosensitive resin composition of the above [1], [2], [3], [4], or [5], wherein the component (C) is contained in 5 to 80 mass% of the photosensitive resin composition.
[7]: The photosensitive resin composition of the above [1], [2], [3], [4], [5], or [6], further comprising (E) a solvent.
[8]: A photosensitive resin film comprising a dried product of the photosensitive resin composition of the above [1], [2], [3], [4], [5], [6], or [7].
[9]: A photosensitive dry film comprising:
   a support film; and
   the photosensitive resin film of the above [8] on the support film.
[10]: A patterning process comprising steps of:
   (i) applying the photosensitive resin composition of the above [1], [2], [3], [4], [5], [6], or [7] onto a substrate to form a photosensitive resin film on the substrate;
   (ii) exposing the photosensitive resin film to light; and
   (iii) developing the exposed photosensitive resin film with a developer to dissolve and remove an unexposed portion, thereby to form a pattern.
[11]: A patterning process comprising steps of:
   (i') sticking the photosensitive resin film of the photosensitive dry film of the above [9] onto a substrate to form a photosensitive resin film on the substrate;
   (ii) exposing the photosensitive resin film to light; and
   (iii) developing the exposed photosensitive resin film with a developer to dissolve and remove an unexposed portion, thereby to form a pattern.
[12]: A light emitting device comprising a cured film obtained by the patterning process of the above [10] or [11].

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A photosensitive resin composition comprising:
(A) a phenolic hydroxy group-containing silicone resin;
(B) a photo-acid generator; and
(C) a quantum dot, wherein
the quantum dot has a surface coating layer containing siloxane.

2. The photosensitive resin composition according to claim 1, wherein the component (C) has a skeleton having a phenolic hydroxy group in the surface coating layer.

3. The photosensitive resin composition according to claim 1 or 2, wherein the component (A) has a repeating unit represented by the following formula (a1) and a repeating unit represented by the formula (b1), 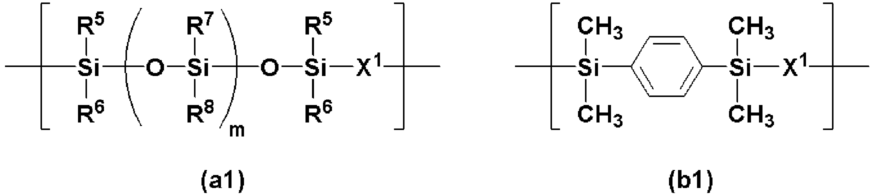
wherein R⁵ to R⁸ each independently represent a monovalent hydrocarbon group having 1 to 8 carbon atoms;
"m" represents an integer of 0 to 600; and X¹ represents a divalent group represented by the following formula (X1), 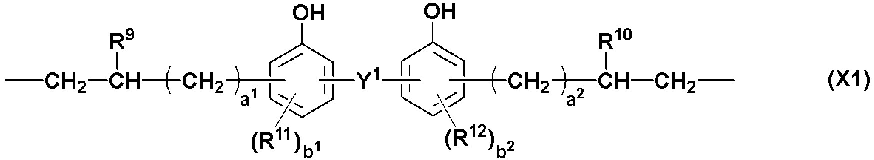
wherein, Y¹ represents a single bond, a methylene group, a propane-2,2-diyl group, a 1,1,1,3,3,3-hexafluoropropane-2,2-diyl group, or a fluorene-9,9-diyl group; R⁹ and R¹⁰ each independently represent a hydrogen atom or a methyl group; R¹¹ and R¹² each independently represent an alkyl group having 1 to 4 carbon atoms or
an alkoxy group having 1 to 4 carbon atoms; a¹ and a² each independently represent an integer of 0 to 7; and b¹ and b² each independently represent an integer of 0 to 2.

4. The photosensitive resin composition according to any one of claims 1 to 3, further comprising at least one crosslinking agent selected from the group consisting of a melamine compound, a guanamine compound, a glycoluril compound, and a urea compound, which have an average of two or more methylol groups, an average of two or more alkoxymethyl groups, or both thereof per molecule, amino condensates modified with formaldehyde or formaldehyde-alcohol, and phenol compounds having an average of two or more methylol groups or alkoxymethyl groups per molecule, as the component (D).

5. The photosensitive resin composition according to any one of claims 1 to 4, wherein the quantum dot as the component (C) has a ligand coordinated on the surface, the surface coating layer has a siloxane bond bonded to the ligand, and a substituent of the ligand has any one or more kinds of an amino group, a thiol group, a carboxy group, a phosphino group, a phosphine oxide group, or an ammonium ion.

6. The photosensitive resin composition according to any one of claims 1 to 5, wherein the component (C) is contained in 5 to 80 mass% of the photosensitive resin composition.

7. The photosensitive resin composition according to any one of claims 1 to 6, further comprising (E) a solvent.

8. A photosensitive resin film comprising a dried product of the photosensitive resin composition according to any one of claims 1 to 7.

9. A photosensitive dry film comprising:
a support film; and
the photosensitive resin film according to claim 8 on the support film.

10. A patterning process comprising steps of:
(i) applying the photosensitive resin composition according to any one of claims 1 to 7 onto a substrate to form a photosensitive resin film on the substrate;
(ii) exposing the photosensitive resin film to light; and
(iii) developing the exposed photosensitive resin film with a developer to dissolve and remove an unexposed portion, thereby to form a pattern.

11. A patterning process comprising steps of:
(i') sticking the photosensitive resin film of the photosensitive dry film according to claim 9 onto a substrate to form a photosensitive resin film on the substrate;
(ii) exposing the photosensitive resin film to light; and
(iii) developing the exposed photosensitive resin film with a developer to dissolve and remove an unexposed portion, thereby to form a pattern.

12. A light emitting device comprising a cured film obtained by the patterning process according to claim 10 or 11.
